# EUROPEAN PATENT APPLICATION

(11) **EP 0 713 306 A1**
(43) Date of publication of application: **22.05.1996**
(21) Application number: 95307916.7
(22) Date of filing: 06.11.1995
(51) Int. Cl.: H04L 27/12, H03C 3/09

(54) **VCO-based frequency modulation system and method**

(30) Priority: 16.11.1994 US 340516
(71) Applicant: AT&T Corp., New York, NY 10013-2412 (US)
(72) Inventor: Ahmed, Syed M., Flemington, New Jersey 08822 (US); Kumar, Sanjay, Parsippany, New Jersey 07054 (US)
(74) Representative: Buckley, Christopher Simon Thirsk

(57) **Abstract**

In a data modulating system the data stream (102) supplied to a modulating VCO (101) is filtered (in 108) before application to the VCO by increasing the low frequency gain of the data applied to the VCO. This increased gain counteracts a cancellation of low frequency data by the VCO because of diminished effectiveness of the VCO control signal due to low frequency data.

## Description

### Field of the Invention

This invention relates to voltage controlled oscillators (VCOs) and in particular to VCOs used for modulating data.

### Background of the Invention

A voltage controlled oscillator (VCO) has a variable frequency signal output responsive to an applied voltage level. VCOs are used for many applications including supplying frequency modulated signals for the transmission of data and voice information. The VCO providing the modulated data signal typically has difficulty modulating data having low frequencies relative to the normal frequency range of the data.

### Summary of the Invention

According to the invention, a data modulating VCO is provided as claimed in claim 1.

In a data modulating system, the data stream supplied to a modulating VCO is filtered before application to the VCO to increase the low frequency gain of the data applied to the VCO. The filtering is performed by an active filter which increases the gain of the signal at the lower frequencies. This increased gain counteracts a cancellation of low frequency data by the VCO because of diminished effectiveness of the VCO control signal with low frequency data.

### Brief Description of the Drawing

FIG. 1 is a block schematic of a VCO modulating system;
FIG. 2 is a graph of frequency response of an uncompensated VCO;
FIG. 3 is a graph of the frequency response of a data filter according to the invention; and
FIG. 4 is a graph of the response of the VCO of the modulating system receiving filtered data from the data filter of FIG. 3.

### Detailed Description

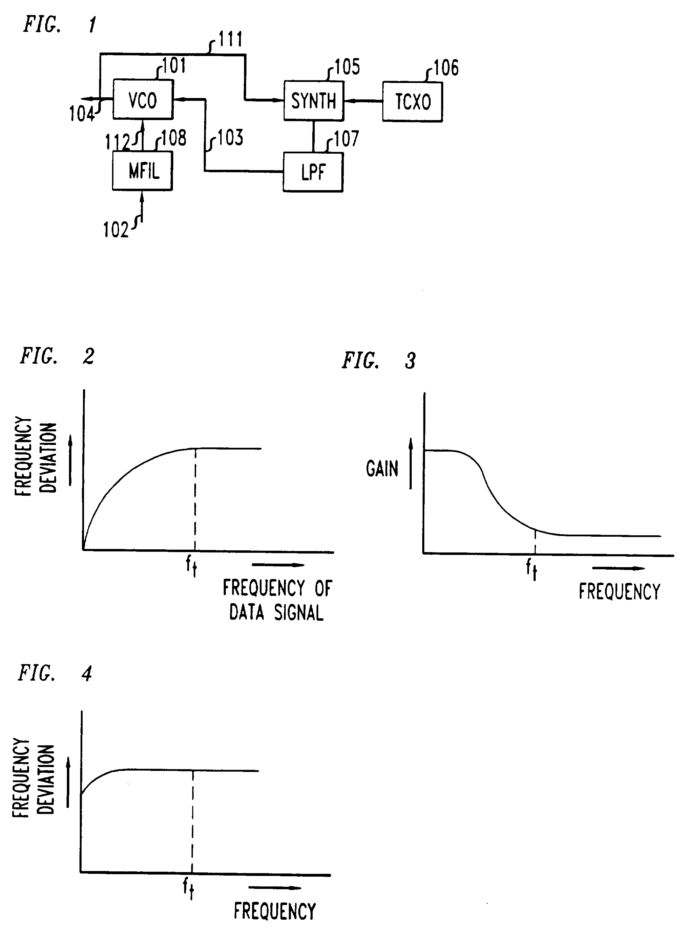

A data modulation system, such as shown in FIG. 1, utilizes a voltage controlled oscillator 101 to generate a signal frequency modulated by a data stream applied to it from a data source such as the data source terminal 102. A control voltage applied to a control voltage input 103 of the VCO determines its reference frequency of operation. In the illustrative embodiment, the control voltage is generated by a frequency synthesizer 105 in response to two frequency inputs supplied from the output 104 of the VCO and by a temperature compensated crystal oscillator (TCXO) 106. The output of the frequency synthesizer, at output lead 109, is applied to a low pass filter 107 to the control voltage input 103 of the VCO 101.

The output voltage feedback from the output lead 109 to the input lead 111 of the synthesizer 105 is divided by a prescaled circuit inside the synthesizer and compared with the frequency signal of the TCXO 106 in a phase comparator within the synthesizer. The result of this comparison is a control voltage applied to the low pass filter which removes high frequency components and applies a filtered control voltage to the control voltage input 103 of the VCO 101. This synthesizer 105 and the low pass filter 107 comprise a classical phase lock loop in which the VCO output is phase locked to a frequency derived from the TCXO frequency.

The VCO 101 operates as a frequency modulator in which data signals are applied to the VCO to adjust its control voltage as supplied to generate a signal frequency which is a modulated signal representative of the applied data signal. A characteristic response of the VCO 101 to variations in frequency of the data signal is shown in the graph of FIG. 2. Below a threshold frequency fₜ the frequency deviation response to the frequency of the applied data signal decreases rapidly to a low or zero value as the frequency of the data signal tends toward zero. Below the threshold frequency fₜ the modulating signal frequency (i.e. the data signal) is less than the loop filter frequency and this causes partial cancellation of the voltage control signal. This causes severe distortion in the modulated data and results in distorted data when it is demodulated.

A modulating data filter 108 is inserted in the path of the data signal applied to the VCO 101. It has a frequency response of gain to frequency as shown in the graph of FIG. 3. It has an S shape with high gain at near zero frequency with a gradual transition to constant gain beginning at the threshold frequency fₜ. This filter 108 boosts low frequency data signals in frequency allowing the VCO to present a relatively flat response downward from the threshold frequency fₜ to DC. This flat response is illustrated in the graph of FIG. 4 which shows the overall response of the VCO 101 to data signal frequency with the filter 108 in the modulating system. The filter, in the illustrative embodiment, is an active filter constructed with operational amplifiers or suitable equivalent digital circuitry.

## Claims

1. In a data modulating system for a cellular transmitter: a system comprising:
a voltage controlled oscillator (VCO) having a control voltage input, a data input and a output for modulated data signals and a characteristic response to the control voltage in which a frequency deviation in its signal response drops sharply below a threshold frequency that is greater that a frequency of a portion of the data input;
a reference frequency source;
a frequency synthesizer connected to receive an output of the reference frequency source and the output of the VCO and the synthesizer having a frequency output;
CHARACTERIZED BY:
a low pass filter having an input connected to receive the frequency of the synthesizer and an output to provide a voltage to the control voltage input of the VCO;
a data source terminal;
a modulating data filter for interconnecting the data source terminal to the data input of the VCO; the modulating data filter having a gain frequency characteristic to counteract a control voltage response of the VCO that reduces frequency deviation of its output in response to a drop in data input with a curve shape of high gain of large frequency merging in a S shaped curve into a lower constant gain level above the threshold frequency.

2. In a data modulating system for a cellular transmitter as claimed in claim 1: a system comprising:
wherein the modulating data filter is an active filter.

3. In a data modulating system for a cellular transmitter as claimed in claim 1: a system comprising:
wherein the reference frequency source is a crystal oscillator.

4. A method of modulating data applied to a voltage controlled oscillator (VCO) having a frequency response characteristic such that its signal response drop sharply below a threshold frequency permitting cancellation of low frequency data; including the steps of:
accepting a stream of data at an input;
CHARACTERIZED BY:
filtering the data presented at the input with a filter function that adjusts the gain of signal through put such that low frequency signals below the frequency threshold are increased in gain and high frequency signals above the frequency threshold have a low gain relative to the increase in gain;
applying the filted data to the voltage controlled oscillator.

5. A method of modulating data as claimed in claim 4, including the step of:
generating a reference frequency in response to a crystal oscillator and applying the reference frequency through a low pass filter to the VCO.

6. A method of modulating data as claimed in claim 5, including the step of:
using a filter function having a curve shape of high gain of large frequency merging in a S shaped curve into a lower constant gain level above the threshold frequency.
